Europäisches Patentamt

European Patent Office

Office européen des brevets

(11) Veröffentlichungsnummer: **0 201 692**
**A1**

(12) # EUROPÄISCHE PATENTANMELDUNG

(21) Anmeldenummer: 86103567.3

(22) Anmeldetag: 17.03.86

(51) Int. Cl.⁴: **G01R 23/173 , G01R 31/28**

(30) Priorität: **22.03.85 DE 3510530**

(43) Veröffentlichungstag der Anmeldung:
**20.11.86 Patentblatt 86/47**

(84) Benannte Vertragsstaaten:
**DE FR GB IT NL**

(71) Anmelder: **Siemens Aktiengesellschaft Berlin
und München
Wittelsbacherplatz 2
D-8000 München 2(DE)**

(72) Erfinder: **Brust, Hans-Detlef
Martin-Luther-Strasse 2
D-6602 Dudweiler(DE)**
Erfinder: **Otto, Johann, Dipl.-Ing.
Pater-Hammerschmid-Strasse 4
D-8170 Bad Tölz(DE)**

(54) **Verfahren zur Auswertung einer Messspannung mittels einer bandbreitenbegrenzten Auswerteschaltung und Anordnung zur Durchführung des Verfahrens.**

(57) Zur Auswertung eines von einem variierbaren Parameter abhängigen Meßsignals wird zunächst mit einer breitbandigen Auswerteschaltung (11) ermittelt, ob ein interessierender Teilbereich des gesamten Variationsbereiches des Parameters erreicht ist. Ist das der Fall, so erfolgt eine Verringerung der Bandbreite der Auswerteschaltung und eine Verringerung der Variationsgeschwindigkeit des Parameters, um in dem interessierenden Teilbereich mit hoher Empfindlichkeit auswerten zu können.

FIG 1

EP 0 201 692 A1

Rank Xerox

## Verfahren zur Auswertung einer Meßspannung mittels einer bandbreitenbegrenzten Auswerteschaltung und Anordnungen zur Durchführung des Verfahrens

Die Erfindung bezieht sich auf ein Verfahren zur Auswertung einer Meßspannung mittels einer bandbreitenbegrenzten Auswerteschaltung nach den Oberbegriffen der Ansprüche 1 und 3 sowie auf Anordnungen zur Durchführung des Verfahrens.

Bei Meßverfahren dieser Art muß man die Auswerteschaltung möglichst schmalbandig ausbilden, um eine hohe Empfindlichkeit zu erreichen. Das verringert aber erheblich die Meßgeschwindigkeit. Will man umgekehrt eine kurze Meßzeit erreichen, so muß man die Bandbreite der Auswerteschaltung erhöhen und damit eine Verminderung der Empfindlichkeit in Kauf nehmen.

Der Erfindung liegt die Aufgabe zugrunde, ein Verfahren der eingangs genannten Art anzugeben, mit dem eine Verringerung der Meßzeit ohne gleichzeitige Verminderung der Empfindlichkeit erreicht wird. Diese Aufgabe wird durch eine Ausbildung des Verfahrens nach dem kennzeichnenden Teil des Patentanspruchs 1 gelöst. Gemäß weiterer Erfindung wird die Aufgabe auch durch eine Ausbildung des Verfahrens nach dem kennzeichnenden Teil des Patentanspruchs 3 gelöst.

Das Verfahren nach der Erfindung zeichnet sich insbesondere dadurch aus, daß lediglich die interessierenden Bereiche der Variationsbreite des Parameters mit relativ geringer Änderungsgeschwindigkeit durchlaufen werden, während in den übrigen Bereichen eine höhere Änderungsgeschwindigkeit vorliegt. Dadurch ergibt sich eine beträchtliche Verringerung der Meßzeit, die jedoch nicht zu einer Verringerung der Meßempfindlichkeit führt, weil für die Dauer der Umschaltung auf die niedrigere Änderungsgeschwindigkeit eine Auswertung der Meßspannung mittels einer schmalbandigen oder schmalbandig geschalteten Auswerteschaltung erfolgt.

Die Ansprüche 2 und 4 bis 6 sind auf bevorzugte Ausgestaltungen der Verfahren nach Anspruch 1 oder 3 gerichtet, während die Ansprüche 7 bis 13 Anordungen zur Durchführung des Verfahrens nach der Erfindung betreffen.

Die Erfindung wird nachfolgend der Zeichnung näher erläutert. Dabei zeigt:

Fig. 1 eine prinzipielle Anordung zur Durchführung des erfindungsgemäßen Verfahrens,

Fig. 2 eine zur Durchführung des erfindungsgemäßen Verfahrens geeignete Anordnung auf dem Gebiet der elektronenstrahlinduzierten Lumineszenzmessung, und

Fig. 3 eine Anordnung zur Durchführung des erfindungsgemäßen Verfahrens bei der Spektralanalyse eines Meßsignals.

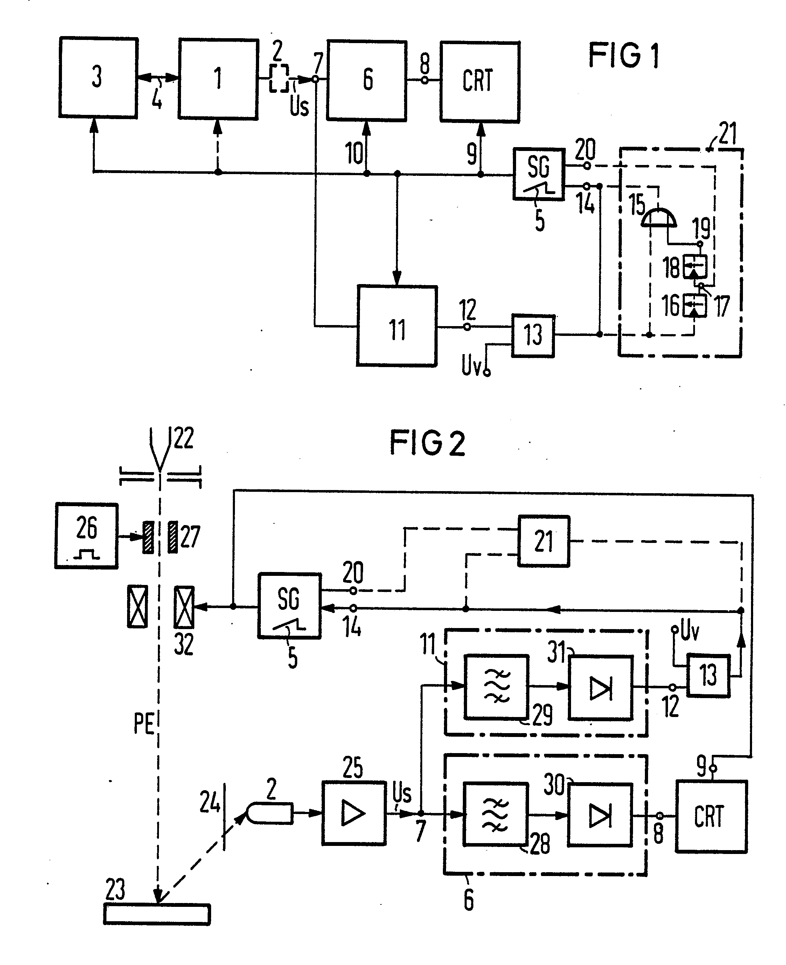

In Fig. 1 wird von einem Meßsignal Us ausgegangen, daß mit seiner Amplitude und/oder Frequenz eine Aussage über beliebige zu messende Eigenschaften eines Meßobjekts bzw. einer Probe 1 zuläßt, die von einem variierbaren Parameter abhängig sind. Wird von der Probe 1 ein nicht elektrisches Meßsignal abgegeben, so kann dieses in einem Detektor 2 in ein elektrisches umgeformt werden.

Die Probe 1 kann dabei insbesondere mit elektrischen Signalen angesteuert oder stimuliert werden, die von einer Ansteuereinrichtung 3 erzeugt und der Probe über eine Leitung 4 zugeführt werden. Der Parameter wird mittels eines Signalgenerators SG, der ein Rampen-oder Treppensignal 5 abgibt, in seiner Größe oder Wirksamkeit gesteuert. Die Steilheit der Anstiegsflanke des Signals 5 bestimmt dabei die Änderungsgeschwindigkeit des Parameters.

Das Meßsignal Us wird einer schmalbandigen Auswerteschaltung 6 über deren Eingang 7 zugeführt, in dieser selektiert und zu einem Ausgangssignal verarbeitet (insbesondere moduliert bzw gleichgerichtet), das an den Intensitätssteuereingang 8 oder einen anderen Steuereingang einer Bildröhre CRT gelegt wird. Wenigstens eine der beiden Ablenkeinrichtungen von CRT kann vom Signalgenerator SG über eine Leitung 9 angesteuert werden. Weiterhin kann auch die Auswerteschaltung 6 von SG angesteuert sein, was durch die Leitung 10 angedeutet ist. Insbesondere kann die Auswerteschaltung 6 ein über einen Frequenzbereich durchstimmbares schmalbandiges Bandpaßfilter enthalten, dessen Mittenfrequenz von der jeweiligen Amplitude der Spannung an 10 abhängig ist.

Eine zweite Auswerteschaltung 11 ist im wesentlichen wie die Auswerteschaltung 6, jedoch breitbandiger als diese ausgebildet. Sie liegt mit ihrem Eingang am Schaltungspunkt 7 und ist somit der Auswerteschaltung 6 eingangsseitig parallel geschaltet oder erhält ihr Eingangssignal von der Auswerteschaltung 6. Das bezieht sich auch auf die Ansteuerung durch den Signalgenerator SG. Das am Ausgang 12 von 11 auftretende Ausgangssignal gelangt zu einem Komparator 13, der mit einer insbesondere einstellbaren Vergleichsspannung Uv beaufschlagt ist.

Übersteigt das Augangssignal von 11 den Wert von Uv, so gelangt es an einen Steuereingang 14 des Signalgenerators SG.

Nach dem erfindungsgemäßen Verfahren wird im Verlauf der Auswertung von Us der z.B. die Amplitude von Us beeinflussende Parameter durch die Ausgangsspannung 5 des Signalgenerators SG variiert. Dabei soll die Auswertung von Us nur innerhalb eines oder mehrerer Teilbereiche innerhalb der Änderungsbreite des Parameters interessieren, während in den übrigen Teilbereichen das Meßsignal US keine interessierende Information enthält (insbesondere seine Amplitude null ist). Man geht nun so vor, daß die durch SG bestimmte Änderungsgeschwindigkeit des Parameters zunächst sehr hoch gewählt wird. Dabei entspricht die hohe Änderungsgeschwindigkeit etwa einem durch die Bandbreite von 11 vorgegebenen Maximalwert. Sobald man aber in den interessierenden Parameterteilbereich kommt, in dem am Ausgang 12 ein Ausgangssignal erhalten wird, dient dieses zum Umschalten des Signalgenerators SG auf eine niedrigere Änderungsgeschwindigkeit für den Parameter. Dabei wird dann Us wegen der langsamen Änderung des Parameters in der schmalbandigen Auswertesschaltung 6 mit hoher Empfindlichkeit ausgewertet. Das hierbei auftretende Ausgangssignal wird zur Steuerung, insbesondere Intensitätssteuerung der Bildröhre CRT verwendet. Wird der interessierende Teilbereich innerhalb der Variationsbreite des Parameters wieder verlassen, so verschwindet das Ausgangssignal am Schaltungspunkt 12, so daß auch der Steuereingang 14 von diesem Signal freigeschaltet wird und SG wieder auf eine hohe Änderungsgeschwindigkeit für den Paramter umgeschaltet wird. Obwohl sich hierdurch die gesamte Meßzeit ganz wesentlich verringert, wird die Auswertung von Us in den wirklich interessierenden Teilbereichen der Variationsbreite - schmalbandig und daher mit hoher Empfindlichkeit durchgeführt.

Nach einer anderen Ausgestaltung der Anordnung nach Fig. 1 kann die erste Auswerteschaltung 6 in ihrer Bandbreite veränderbar sein. Hierbei arbeitet sie zunächst in einem breitbandigen Betriebsmodus, wobei der Signalgenerator SG auf eine große Änderungsgeschwindigkeit des Parameters eingestellt ist. Während des Auftretens eines Ausgangssignals am Ausgang von 6 wird dann ein Eingang dieser Auswerteschaltung mit diesem Signal angesteuert, wobei eine Umschaltung der Auswerteschaltung 6 in einen schmalbandigen Betriebsmodus erfolgt. Gleichzeitig wird auch über den Ausgang von 6 der Eingang 14 von SG angesteuert, so daß SG durch das Ausgangssignal auf eine niedrigere Änderungsgeschwindigkeit für den Parameter umgeschaltet wird. Die weitere Auswertung des Ausgangssignals von 6 erfolgt in der bereits beschriebenen Weise.

Nach einer Weiterbildung der Anordnung von Fig. 1 kann der Ausgang 12 auch mit dem ersten Eingang eines ODER-Gatters 15 verbunden sein, dessen Ausgang an den Steuereingang 14 von SG gelegt ist. In diesem Fall ist der Ausgang 12 auch mit dem Takteingang eines Monoflops 16 beschaltet, dessen Ausgang 17 mit dem Takteingang eines zweiten Monoflops 18 verbunden ist. Dessen Ausgang 19 liegt an einem zweiten Eingang des Gatters 15. Der Ausgang 17 ist schließlich mit einem zweiten Steuereingang 20 von SG verbunden, über den die Änderungsrichtung für den Parameter umgekehrt werden kann. Sobald ein Ausgangssignal der breitbandigen Auswerteschaltung 11 erhalten wird, kippt das Monoflop 16 um und liefert über 17 ein Signal, das eine Umkehrung der Änderungsrichtung des Parameters und ebenso eine Umkehr der Laufrichtung des Elektronenstrahls von CRT bewirkt. Die Länge des von 16 abgegebenen Signals bestimmt dabei das Ausmaß des sich für den Parameter und den Elektronenstrahl ergebenden Rücksprungs, wobei dieser Rücksprung zweckmäßigerweise mit einer hohen Änderungsgeschwindigkeit vorgenommen wird. Nach Beendigung des Rücksprungs wird der Parameter wieder in der ursprünglichen Richtung verändert und der Elektronenstrahl wieder in der ursprünglichen Richtung abgelenkt. Während des Rücksprungs kann der Elektronenstrahl ausgetastet werden. Dabei gibt das durch die Rückflanke des von 16 abgegebenen Signals gekippte Monoflop 18 innerhalb seiner Eigenzeit ein Signal ab, das dem Steuereingang 20 von SG zugeführt wird und eine langsame Änderungsgeschwindigkeit bewirkt, auch wenn durch den Rücksprung am Ausgang 12 kein Ausgangssignal mehr vorhanden ist. Durch diese Weiterbildung kann vermieden werden, daß wegen der hohen Änderungsgeschwindigkeit des Parameters an den unmittelbaren Grenzen der interessierenden Teilbereiche innerhalb der Variationsbreite die Genauigkeit der Auswertung an diesen Stellen verringert wird.

Fig. 2 zeigt eine Anordnung zur Durchführung des erfindungsgemäßen Verfahrens bei einer Kathodolumineszenzmessung. Dabei bilden die aus einer Elektronenquelle 22 austretenden Elektronen einen Primärstrahl PE. Trifft dieser auf einer Punkt einer Probe 23, so versetzen an diesem eindringende Primärelektronen einen Teil der Probenatome kurzzeitig in einen angeregten Zustand. Der Übergang in den Grundzustand kann dann strahlend erfolgen, d.h. das entsprechende Probenatom gibt seine überschüssige Energie als Photon ab. Die entstehende Lichtstrahlung kann registriert werden und läßt Rückschlüsse auf Bandstrukturen und Energieniveaus zu. Filtert man nur Licht einer bestimmten Wellenlänge, das durch einen ganz bestimmten Übergang erzeugt wird, durch ein Filter 24 aus, so lassen sich verschiedene Atomsorten unterscheiden. Zum Nachweis der ausgefilterten Lichtwellen dient ein Detektor, der einen Photomultiplier enthält, welcher ein sekundäres elektrisches Signal abgibt, das nach Verstärkung in einem Vorverstärker 25 als Meßsignal Us zur Verfügung steht. Da die rzeugte Lichtintensität sehr gering ist, intensitätsmoduliert man häufig den Primärstrahl PE mit einer Frequenz f, was mittels eines Austastgenerators 26 und einer Modulationseinrichtung 27 geschieht und selektiert die Frequenz f aus dem Meßsignal Us mittels zweier in den Auswerteschaltungen 6 und 11 enthaltenen Bandpaßfilter 28 und 29, deren Mittenfrequenzen jeweils mit f übereinstimmen. Den Filtern 28 und 29 sind jeweils Amplitudendemodulatoren 30 und 31 nachgeschaltet. Der Parameter, der Us beeinflußt, besteht hierbei aus dem Ort der Probe, der jeweils vom Primärstrahl PE getroffen wird. Weiterhin beeinflußt SG, der in diesem Fall als Rastergenerator bezeichnet wird, die Ablenksysteme 32 des Rasterelektronenmikroskops so, daß PE die Probe in einzelnen Zeilen abrastert. Über die Leitung 9 wird auch der Elektronenstrahl von CRT so abgelenkt, daß er in entsprechenden Zeilen den Bildschirm überstreicht. Auf diese Weise wird durch die Auswertung von Us die Verteilung einer bestimmten Substanz in einer inhomogenen Probe 23 auf dem Bildschirm von CRT abgebildet.

Zur Anpassung der Änderungsgeschwindigkeit des Parameters, d.h. in diesem Fall der Rastergeschwindigkeit, an die jeweils interessierenden und nicht interessierenden Teilbereiche innerhalb der Variationsbreite des Parameters, dient die breitbandige Auswerteschaltung 11, die den Eingang 14 des Rastergenerators SG entsprechend ansteuert. Tritt am Ausgang 12 ein Ausgangssignal auf, so wird die jeweils aufgesuchte Stelle auf der Probe langsam abgerastert, andernfalls sehr schnell.

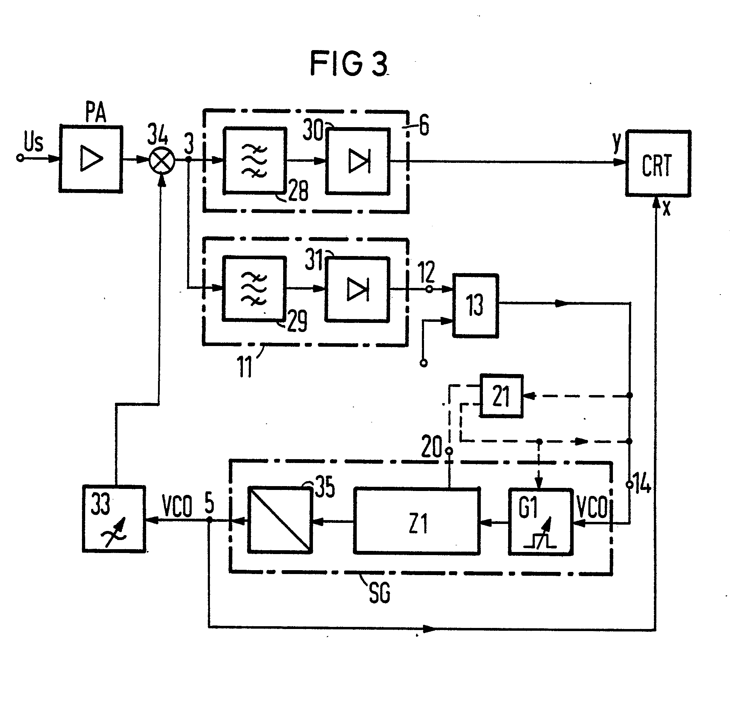

Fig. 3 zeigt die Anwendung des erfindungsgemäßen Verfahrens auf die Spektralanalyse eines hochfrequenten Meßsignals Us. Dieses wird nach einer Verstärkung in einem Vorverstärker PA mit Hilfe eines Mischoszillaors 33 und einer Mischstufe 34 auf eine feste Zwischenfrequenz gemischt, auf die sowohl das schmalbandige Bandpaßfilter 28 als auch das breitbandige Bandfilter 29 in den Auswerteschaltungen 6 und 11 abgestimmt sind. Der Mischoszillator wird durch das Rampen-oder Treppensignal 5 des Signalgenerators SG in der Frequenz durchgestimmt. Das eine Ablenksystem der Bildröhre CRT wird mit dem Signal 5 angesteuert, das andere mit dem Ausgangssignal der Auswerteschaltung 6. Auf dem Bildschirm sind dann die einzelnen beim Durchstimmen des Mischoszillators aufgefundenen Frequenzen des Meßsignals Us als Auslenkungen von einer Frequenzachse erkennbar. Über eine vom Ausgang 12 gesteuerte Umschaltung der Durchstimmgeschwindigkeit des Mischoszillators werden die nicht interessierenden, schnell zu überstreichenden Frequenzbereiche von den Frequenzbereichen, in denen Spektralanteile von Us vermutet werden und die deshalb langsam zu überstreichen sind, unterschieden.

Der in Fig. 1 mit 21 bezeichnete Schaltungsteil, der einen Rücksprung des jeweiligen Parameters bewirkt, ist in analoger Weise auch in den Anordnungen nach den Figuren 2 und 3 einsetzbar.

Fig. 3 läßt eine zweckmäßige Ausgestaltung des Signalgenerators SG erkennen. Diese besteht aus einem Taktoszillator G1, der durch ein am Eingang 14 anliegendes Signal in seiner Taktfrequenz beeinflußt. Man kann G1 auch als einen VCO (Voltage Controlled Oscillator) bezeichnen. Ein nachgeschalteter Zähler Z1 zählt die von G1 abgegebenen Taktimpulse, wobei über einen Digital-Analog-Wandler ein dem jeweiligen Zählergebnis amplitudenmäßig entsprechendes analoges Signal abgeleitet wird. Dieser stellt dann insbesondere bei einer periodischen Rücksetzung von Z1 auf einen Anfangswert das Rampen-oder Treppensignal 5 dar. Zur Umkehrung der Änderungsrichtung des Parameters wird dem Eingang 20 ein Signal zugeführt, das die Zählrichtung von Z1 umkehrt.

Die zuvor beschriebene Anordnung mit nue einer einzigen in ihrer Bandbreite veränderbaren Auswerteschaltung läßt sich analog auf die Anordnungen nach Fig. 2 und Fig. 3 übertragen.

Anstelle der Bildröhre CRT kann auch jede andere Aufzeichnungseinrichtung, insbesondere ein Rechner oder ein xy-Schreiber, verwendet werden.

Die Umschaltung der Bandbreite kann sowohl in diskreten Schritten als auch kontinuierlich erfolgen.

In Abwandlung des bisher beschriebenen Verfahrens kann auch zunächst in einer ersten Variationssequenz der Parameter variiert und das Ausgangssignal der ersten bzw. zweiten Auswerteschaltung zwischengespeichert werden. In einer zweiten Variationssequenz, die nur noch die interessierenden Variationsbereiche zu umfassen braucht, kann sodann das gespeicherte Signal zur Änderung der Variationsgeschwindigkeit des Parameters und gegebenenfalls Veränderung der Bandbreite der ersten Auswerteschaltung herangezogen werden.

In Abwandlung der bisher beschriebenen Anordnungen muß die Auswerteschaltung nicht unbedingt ein rein elektrisches System sein. Liefert die Probe etwa nichtelektrische Signale, so können andere, insbesondere optische Verarbeitungssysteme, insbesondere zur Selektion eingesetzt werden. Eine Umwandlung in ein elektrisches Signal zur Aufzeichnung kann danach, insbesondere mittels eines Detektors, erfolgen. Auch müssen die beiden Auswerteschaltungen nicht vollständig parallel gschaltet sein, sondern können gemeinsame Komponenten (in Fig. 2 z.B. das Filter 24) benutzen.

In Fig. 2 kann anstelle des Rasterelektronenmikroskops auch jedes andere Rastermikroskop, z.B. Laser-Rastermikroskop, treten, dessen Primärstrahl Lumineszenz zu induzieren vermag.

Bezugszeichenliste

1 Probe

2 Detektor

3 Ansteuereinrichtung

4 Leitung

5 Rampensignal

6 schmalbandige Auswerteschaltung

7 Eingang von 6

8 Intensitätssteuereingang

9, 10 Leitungen

11 breitbandige Auswerteschaltung

12 Ausgang von 11

13 Komparator

14 Steuereingang von SG

15 ODER-Gatter

16 Monoflop

17 Ausgang von 16

18 Monoflop

19 Ausgang von 18

20 Steuereingang von SG

21 Schaltungsteil

22 Elektronenquelle

23 Probe

24 Filter

25 Vorverstärker

26 Austastgenerator

27 Modulationseinrichtung

28, 29 Bandpaßfilter

30, 31 Amplitudendemodulatoren

32 Ablenksysteme

33 Mischoszillator

34 Mischstufe

CRT Bildröhre

f Frequenz

G1 Taktoszillator

PA Vorverstärker

PE Primärstrahl

SG Signalgenerator

Us Meßsignal

Uv Vergleichsspannung

Z1 Zähler

**Ansprüche**

1. Verfahren zur Auswertung eines Meßsignals mittels einer bandbreitenbegrenzten ersten Auswerteschaltung, bei dem das Meßsignal von einem während der Auswertung innerhalb einer bestimmten Variationsbreite variierbaren Parameter abhängig ist, **dadurch gekennzeichnet**, daß bei einer schmalbandigen Ausbildung der ersten Auswerteschaltung eine zumindest teilweise entsprechend der ersten ausgebildete, jedoch breitbandigere zweite Auswerteschaltung verwendet wird, daß ein Ausgangssignal der zweiten Auswerteschaltung zu einer für die Dauer des Auftretens dieses Ausgangssignals erfolgenden Umschaltung der Änderungsgeschwindigkeit des Parameters von einem höheren auf einen niedrigeren Wert herangezogen wird und daß das Ausgangssignal der ersten Auswerteschaltung der Auswertung zugrundegelegt wird.

2. Verfahren nach Anspruch 1, **dadurch gekennzeichnet**, daß das während einer ersten Variationssequenz des Parameters erhaltene Ausgangssignale der zweiten Auswerteschaltung zunächst zwischengespeichert wird und sodann während einer zweiten Variationssequenz zur Umschaltung der Änderungsgeschwindigkeit des Parameters herangezogen wird.

3. Verfahren zur Auswertung eines Meßsignals mittels einer bandbreitenbegrenzten ersten Auswerteschaltung, bei dem das Meßsignal von einem während der Auswertung innerhalb einer bestimmten Variationsbreite variierbaren Parameter abhängig ist, **dadurch gekennzeichnet**, daß eine in ihrer Bandbreite veränderbare erste Auswerteschaltung herangezogen wird, daß diese zunächst in einem breitbandigen Betriebsmodus verwendet wird, wobei für den variierbaren Parameter eine höhere Änderungsgeschwindigkeit vorgesehen wird, und daß ein an der ersten Auswerteschaltung auftretendes Ausgangssignal dazu benutzt wird, um für die Dauer des Auftretens desselben eine diskrete oder kontinuierlich erfolgende Umschaltung der ersten Auswerteschaltung in einen - schmalbandigeren Betriebsmodus ·vorzunehmen, wobei für die Dauer dieser Umschaltung eine Umschaltung der Änderungsgeschwindigkeit des variierbaren Parameters von einem höheren auf einen niedrigeren Wert erfolgt, und daß das Ausgangssignal der Auswertung zugrundegelegt wird.

4. Verfahren nach Anspruch 3, **dadurch abgewandelt**, daß die Umschaltung der ersten Auswerteschaltung in den schmalbandigen Betriebsmodus nicht während des Auftretens eines Ausgangssignals desselben vorgenommen wird, sondern daß während einer ersten Variationssequenz des Paramters das Ausgangssignal der ersten Auswerteschaltung zunächst zwischengespeichert wird und sodann während einer zweiten Variationssequenz zur Umschaltung der ersten Auswerteschaltung in den schmalbandigen Betriebsmodus und zur Umschaltung der Änderungsgeschwindigkeit des variierbaren Parameters auf den niedrigeren Wert herangezogen wird.

5. Verfahren nach·einem der Ansprüche 1 bis 4, **dadurch gekennzeichnet**, daß das Meßsignal von den beim Auftreffen eines Korpuskularstrahls auf der Probe in dieser durch Übergang der Probenatome aus dem erregten in den Grundzustand abgegebenen Photonen über einen Detektor abgeleitet wird, daß der Korpuskularstrahl mit einer Pulsfrequenz intensitätsmoduliert wird, daß die erste und gegebenenfalls die zweite Auswerteschaltung auf diese Pulsfrequenz abgestimmt sind, daß ein Rastergenerator (SG) zur Ablenkung des Korpuskularstrahls über die Probe verwendet wird, daß der Rastergenerator zur Änderungung der Rastergeschwindigkeit von einem höheren auf einen niedrigeren Wert über den Ausgang der ersten oder zweiten Auswerteschaltung (6, 11) angesteuert wird und daß das Ausgangssignal der ersten Auswerteschaltung zusammen mit den vom Rastergenerator (SG) erzeugten Signalen einer Aufzeichnungseinrichtung, insbesondere einem Rechner oder einer Bildröhre, zugeführt wird, deren Ablenksysteme insbesondere von dem Rastergenerator angesteuert werden.

6. Verfahren nach einem der Ansprüche 1 bis 4, **dadurch gekennzeichnet**, daß das Meßsignal einer Frequenzanalyse unterzogen wird, daß es mittels einer Mischstufe (34) und eines in seiner Frequenz durchstimmbaren Mischoszillators (33) auf eine feste Zwischenfrequenz gemischt wird, daß die erste und gegebenenfalls die zweite Auswerteschaltung auf diese feste Zwischenfrequenz abgestimmt sind, daß ein zur Durchstimmung des Mischoszillators (33) dienender Generator (SG) bezüglich der Flankensteilheit des von ihm erzeugten Signals steuerbar ist, daß diese Steuerung mittels des Ausgangssignals der ersten oder zweiten Auswerteschaltung vorgenommen wird und daß die Ausgangsspannung der ersten Auswerteschaltung - (6) in Abhängigkeit von dem Ausgangssignal des Generators (SG) mittels einer Aufzeichnungsvorrichtung, insbesondere einem Rechner oder einer Bildröhre (CRT), dargestellt wird.

7. Anordnung zur Durchführung des Verfahrens nach einem der Ansprüche 1, 2, 5 oder 6, **dadurch gekennzeichnet**, daß die erste Auswerteschaltung (6) schmalbandig ausgebildet ist, daß eine entsprechend der ersten, jedoch wesentlich breitbandiger als diese ausgebildete zweite Auswerteschaltung - (11) der ersten zumindest teilweise parallel geschaltet ist und daß das Ausgangssignal der zweiten Auswerteschaltung einem Steuereingang (14) des Rastergenerators oder des Generators (SG) zur Umschaltung auf eine niedrigere Änderungsgeschwindigkeit bezüglich der Amplitude seiner Ausgangsspannung zuführbar ist.

8. Anordnung zur Durchführung des Verfahrens nach einem der Ansprüche 3 bis 6, **dadurch gekennzeichnet**, daß die erste Auswerteschaltung (6) in ihrer Bandbreite veränderbar ausgebildet ist und daß ihr Ausgang mit einem Steuereingang zur Veränderung ihrer Bandbreite sowie mit einem Steuereingang (14) des Rastergenerators oder des Generators (SG) zur Veränderung auf eine niedrigere Änderungsgeschwindigkeit bezüglich der Amplitude seiner Ausgangsspannung verbunden ist.

9. Anordnung nach Anspruch 7 oder 8, **dadurch gekennzeichnet**, daß wenigstens eine der Auswerteschaltungen (6, 11) aus einem Lock-in-Verstärker besteht.

10. Anordnung nach Anspruch 7 oder 8, **dadurch gekennzeichnet**, daß wenigstens eine der Auswerteschaltungen (6, 11) aus einem insbesondere elektrischen oder optischem Bandpaßfilter (28, 29) und einem nachgeschalteten Demodulator, insbesondere Amplitudendemodulator (30,31), besteht.

11. Anordnung nach einem der Ansprüche 7 bis 10, **dadurch gekennzeichnet** , daß der Rastergenerator (SG) mit wenigstens einer Ablenkeinrichtung für den Elektronenstrahl einer Bildröhre (CRT) beschaltet ist, deren Intensitätssteuereingang (8) oder Ablenksteuereingang mit dem Ausgang der ersten Auswerteschaltung (6) verbunden ist.

12. Anordnung nach einem der Ansprüche 7 bis 11, **dadurch gekennzeichnet**, daß der Ausgang der ersten oder zweiten Auswerteschaltung (6, 11) mit einem Steuereingang (20) des Rastergenerators oder des Generators (SG) für eine zeitlich begrenzte Umkehrung der Änderungsrichtung seiner Ausgangsspannung und ein sich anschließendes Rückschalten in die ursprüngliche Änderungsrichtung verbunden ist, wobei zusammen mit diesem Rückschalten die Umschaltung auf eine niedrigere Änderungsgeschwindigkeit bezüglich der Amplitude seiner Ausgangsspannung erfolgt.

13. Anordnung nach einem der Ansprüche 7 bis 12, **dadurch gekennzeichnet**, daß zusammen mit der Umschaltung der Änderungsgeschwindigkeit des Parameters durch das Ausgangssignal der ersten oder zweiten Auswerteschaltung (6, 11) auch die Aufzeichnungseinrichtung, insbesondere die Bildröhre, vom Ausgang der ersten Auswerteschaltung (6) auf ein zusätzliches Signal, insbesondere ein Topographiesignal oder das Ausgangssignal der zweiten Auswerteschaltung (11) umschaltbar ist.

FIG 1

FIG 2

# FIG 3

## EINSCHLÄGIGE DOKUMENTE

| Kategorie | Kennzeichnung des Dokuments mit Angabe, soweit erforderlich, der maßgeblichen Teile | Betrifft Anspruch | KLASSIFIKATION DER ANMELDUNG (Int. Cl.4) |
|---|---|---|---|
| X | DE-B-2 553 705 (SIEMENS AG) <br> * Spalte 3, Zeilen 51-68; Spalte 4, Zeilen 1-47; Spalte 5, Zeilen 20-69; Spalte 6, Zeilen 1-66; Abbildungen 1-4 * | 3-4 | G 01 R 23/173 <br> G 01 R 31/28 |
| Y | | 3-6,8 | |
| A | | 1,2,12 | |
| | --- | | |
| Y | MICROELECTRONICS JOURNAL, Band 11, Nr. 2, März/April 1980, Seiten 35-40, Luton, GB; C.E. JOWETT: "Surface analytical techniques applied to electronic components" <br> * Seite 36, Absatz 3; Abbildungen 1-3; Seite 37, Absatz 5, Abbildungen 5,6 * | 3-6,8 | |
| A | IDEM | 9,11 | RECHERCHIERTE SACHGEBIETE (Int. Cl.4) <br><br> G 01 R <br> H 01 J <br> H 03 J |
| | --- | | |
| A | FR-A-2 312 110 (COMMISSARIAT A L'ENERGIE ATOMIQUE) <br> * Ansprüche 1-19; Abbildungen 1-3 * | 5 | |
| | ---     -/- | | |

Der vorliegende Recherchenbericht wurde für alle Patentansprüche erstellt.

| Recherchenort <br> DEN HAAG | Abschlußdatum der Recherche <br> 17-06-1986 | Prüfer <br> KAUFFMANN J. |
|---|---|---|

Europäisches
Patentamt

# EUROPÄISCHER RECHERCHENBERICHT

Nummer der Anmeldung

EP 86 10 3567

## EINSCHLÄGIGE DOKUMENTE

Seite 2

| Kategorie | Kennzeichnung des Dokuments mit Angabe, soweit erforderlich, der maßgeblichen Teile | Betrifft Anspruch | KLASSIFIKATION DER ANMELDUNG (Int. Cl.4) |
|---|---|---|---|
| A | FUNKSCHAU, Band 52, Nr. 21, Oktober 1980, Seiten 82-84,89, München, DE; M. ARNOLDT: "Aufbau und Wirkungsweise von HF-Spektrumanalysatoren" * Seite 82, Abbildung 1; Seite 83, Absatz: "Die Analysiergeschwindigkeit" * | 1,3,10 | |
| A | ELECTRONICS, Band 46, Nr. 13, 21. Juni 1973, Seiten 116-120, New York, US; J. WEIBEL et al.: "Digital storage improves and simplifies analysis of low-frequency signals" * Seite 120, Absatz: "Adaptive sweep"; Abbildung 8 * | 12 | |

RECHERCHIERTE
SACHGEBIETE (Int. Cl.4)

Der vorliegende Recherchenbericht wurde für alle Patentansprüche erstellt.

| Recherchenort | Abschlußdatum der Recherche | Prüfer |
|---|---|---|
| DEN HAAG | 17-06-1986 | KAUFFMANN J. |

EPA Form 1503 03 82

KATEGORIE DER GENANNTEN DOKUMENTE

X : von besonderer Bedeutung allein betrachtet
Y : von besonderer Bedeutung in Verbindung mit einer anderen Veröffentlichung derselben Kategorie
A : technologischer Hintergrund
O : nichtschriftliche Offenbarung
P : Zwischenliteratur
T : der Erfindung zugrunde liegende Theorien oder Grundsätze

E : älteres Patentdokument, das jedoch erst am oder nach dem Anmeldedatum veröffentlicht worden ist
D : in der Anmeldung angeführtes Dokument
L : aus andern Gründen angeführtes Dokument

& : Mitglied der gleichen Patentfamilie, übereinstimmendes Dokument